# EUROPEAN PATENT APPLICATION

(11) **EP 0 982 767 A1**
(43) Date of publication of application: **01.03.2000**
(21) Application number: 99112775.4
(22) Date of filing: 01.07.1999
(51) Int. Cl.: H01L 21/322, H01L 21/324, H01L 21/265

(54) **Gettering method using a plasma ion introducing step and system for carrying out the same**

(30) Priority: 21.08.1998 JP 23585498
(71) Applicant: Speedfam Co., Ltd., Ohta-ku, Tokyo (JP)
(72) Inventor: Iida, Shinya, Ayase-shi, Kanagawa-ken (JP); Tojo, Ryosuke, Ayase-shi, Kanagawa-ken (JP); Yanagisawa, Michihiko, Ayase-shi, Kanagawa-ken (JP)
(74) Representative: HOFFMANN - EITLE

(57) **Abstract**

A plasma gettering method and a system capable of forming a uniform strain layer inside a wafer without polluting the environment and simple in process. An H₂ and Ar gas are supplied to a discharge location for plasma discharge so as to form H positive ions and Ar positive ions. The side of the silicon wafer (W) arranged with its back surface (Wb) facing the discharge location is made a negative potential with respect to the plasma potential, and H positive ions and Ar positive ions are irradiated over the entire surface of the back surface (Wb) of the silicon wafer (W), whereby strain layers (D1) and (D2) are formed in the silicon wafer (W) . Then the silicon wafer (W) formed with the strain layers (D1) and (D2) are heated to a predetermined temperature to capture heavy metal impurities (M) in the silicon wafer (W) by the strain layers (D1) and (D2).

## Description

### BACKGROUND OF THE INVENTION

### 1. Field of the Invention

The present invention relates to a plasma gettering method for removing harmful impurities from electrically active regions of a wafer and a system for the same.

### 2. Description of the Related Art

PN junction portions and other electrically active regions are formed on the front surfaces of devices produced by the high integration device process. When copper, iron, or other heavy metal impurities segregate at these electrically active regions, the characteristics of the PN junction, the carrier life, and other electrical characteristics end up deteriorating.

Therefore, in the high integration device process, the technique of extrinsic gettering (hereinafter referred to as "E-G") is adopted to apply some sort of processing to the back surface of the silicon wafer forming a device to remove the harmful heavy metal impurities segregated at the electrically active regions.

This E-G includes, mainly, the method of damaging the back surface, the method of depositing a film on the back surface, and the method of diffusing phosphorus.

The back surface damage method is a technique for giving mechanical damage to the back surface of the silicon wafer to getter the heavy metal impurities at this strain layer. The sand blast method is generally used.

That is, silica (SiO₂) particles and alumina (A1₂O₃) particles are blown at a high pressure from a nozzle on to the back surface of the silicon wafer to give strain to the crystals and capture the heavy metal impurities diffused by heat treatment by this strain layer.

The back surface film deposition method is a technique for depositing a thin film on the back surface of the silicon wafer and removing the heavy metal impurities by this film. A polysilicon back sealing (hereinafter referred to as "PBS") method is generally used.

That is, reduced pressure chemical vapor deposition (CVD) is used to deposit a polycrystalline silicon film of a thickness of 1 µm to 2 µm on the back surface of a silicon wafer to capture heavy metal impurities by this polycrystalline silicon film.

The method of diffusing phosphorous is a technique for diffusing phosphorous into crystallines of silicon wafer to combine phosphorous with silicon thereby forming a phosphorous layer. Then, heavy metal impurities are captured by the excess silicon generated by the formation of phosphorous layer.

In the above related arts, however, there were the following problems:

First, with the sand blasting method, since silica particles etc. were blown on the back surface of the silicon wafer, it was necessary to wash off the silica particles etc. deposited on silicon wafer by a high pressure jet of water. Therefore, silica particles etc. were sprayed around the surroundings and caused environmental pollution. Further, a uniform strain layer could not be formed across the entire back surface of the silicon wafer and the gettering effect was small.

Next, with the PBS method, a polycrystalline silicon film promotes the precipitation of oxygen at the time of heat treatment and results in numerous dislocations. Therefore, it was necessary to adjust the initial oxygen concentration of the silicon wafer to the optimum value. The process for this was extremely complicated.

Finally, with the phosphorus diffusion method, to eliminate the effect of the phosphorous on the electrically active regions of the front surface of the silicon wafer, it was necessary to control the diffusion of the phosphorus and form the above phosphorus layer on the back surface of the silicon wafer. The means and control for forming the phosphorus layer on the back surface of the silicon wafer became complicated.

### SUMMARY OF THE INVENTION

The present invention was made to solve the above problems and has as its object to provide a plasma gettering method and a system thereof capable of forming a uniform strain layer inside the wafer layer without polluting the environment and simple in process.

To solve this problem, according to the aspect of the invention, there is provided a plasma gettering method comprising: a gas feed step for feeding a predetermined gas to a discharge location; a strain layer forming step for discharging the gas supplied to the discharge location to generate plasma, making the side of the wafer arranged with its back surface facing the discharge location a negative potential with respect to the plasma potential, irradiating positive ions in the plasma on the entire back surface of the wafer, and thereby forming a strain layer in the wafer; and a heat treatment step for heating the wafer formed with the strain layer in the strain layer formation step to a predetermined temperature to cause the impurities in the wafer to be captured in the strain layer.

Due to this configuration, a predetermined gas is fed to the discharge location in the gas feed step and the gas is converted to plasma by discharge in the strain layer formation step. Further, the wafer side is made a negative potential with respect to the plasma potential, the positive ions in the plasma are irradiated on the back surface of the wafer, and a strain layer is formed in the wafer. By doing this, the wafer having the strain layer is heated to a predetermined temperature at the heating step and the impurities in the wafer are captured by the strain layer.

Note that the gas is converted to a plasma and the positive ions strike the back surface of the wafer or enter inside and give shock to the crystal structure of the wafer to form a strain layer. Therefore, the gas is not limited in type so long as no chemical reaction is caused with the wafer.

Therefore, at least one of hydrogen gas and helium gas is supplied to the discharge location in the gas feed step.

Due to this configuration, the positive ions of the hydrogen and the positive ions of the helium are irradiated on a water and a strain layer is formed in the wafer. Further, since hydrogen positive ions and the helium positive ions are light and small in ion radius, by adjusting the magnitude of the negative potential, it is possible to form a strain layer deep in the wafer.

The aspect of the invention, at least one type of inert gas among inert gases other than helium gas is supplied to the discharge location in the gas feed step.

Due to this configuration, ions of an inert gas other than helium are irradiated on the wafer and a strain layer is formed in the wafer. Further, since the positive ions of the inert gas other than helium are heavy and large in ion radius, the shock given to the wafer is large and therefore it is possible to form a strain layer deep in the wafer in a short time.

The aspect of the invention, at least one type of inert gas among inert gases other than helium gas is added to at least one of hydrogen gas and helium gas and supplied to the discharge location in the gas feed step.

Note that a system for realizing this plasma gettering method also can stand as a product invention.

Therefore, according to the aspect of the invention, there is provided a plasma gettering system comprising: a strain layer forming device having a gas feed unit for feeding a predetermined gas to a discharge location, a plasma generating unit for discharging the gas supplied from the gas feed unit to the discharge location to generate plasma, and a positive ion acceleration unit for making the side of the wafer arranged with its back surface facing the discharge location a negative potential with respect to the plasma potential and irradiating positive ions in the plasma on the entire back surface of the wafer; and a heating device for heating the wafer formed with the strain layer in the strain layer forming device to a predetermined temperature.

### BRIEF DESCRIPTION OF THE DRAWINGS

The above and other objects, features, and advantages of the present invention will become more readily apparent from the following detailed description of presently preferred embodiments of the invention taken in conjunction with the accompanying drawings, in which:
FIG. 1 is a view of the configuration of a plasma gettering system for specifically working the plasma gettering method according to a first embodiment of the present invention;
FIG. 2 is a schematic cross-sectional view of the state of formation of strain layers by H positive ions and Ar positive ions;
FIG. 3 is a schematic cross-sectional view of the action of the strain layers capturing the impurities of heavy metals;
FIG. 4 is a schematic cross-sectional view of a plasma gettering method according to a second embodiment of the present invention;
FIG. 5 is a schematic cross-sectional view of a plasma gettering method according to a third embodiment of the present invention;
FIG. 6 is a schematic cross-sectional view of strain layers formed by various positive ions;
FIG. 7 is a cross-sectional view of a modification of the heating device; and
FIG. 8 is a cross-sectional view of another modification of the heating device.

### DESCRIPTION OF THE PREFERRED EMBODIMENTS

The preferred embodiments of the present invention will be explained next with reference to the drawings.

### (First Embodiment)

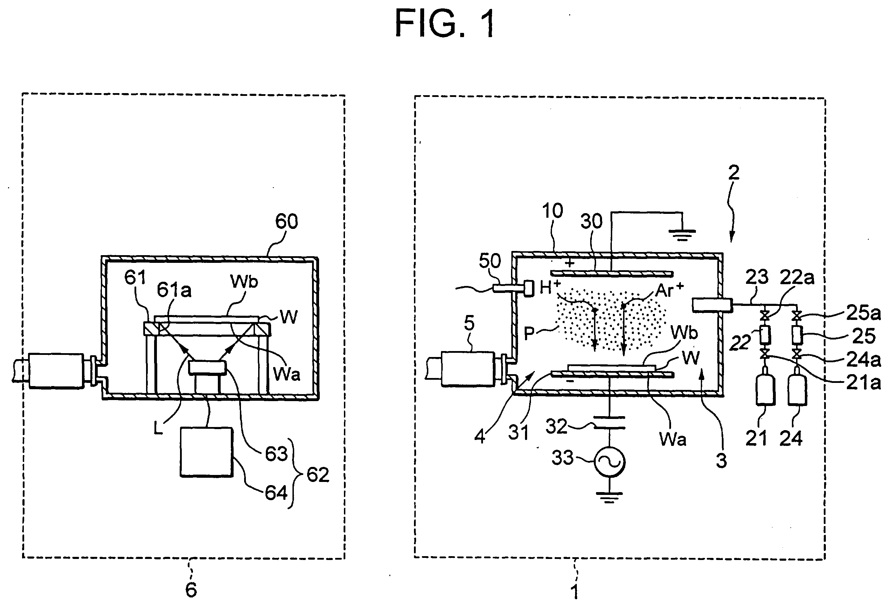

FIG. 1 is a view of the configuration of a plasma gettering system for specifically working the plasma gettering method according to a first embodiment of the present invention.

As shown in FIG. 1, the plasma gettering system is provided with a strain layer formation device 1 and a heating device 6.

The strain layer formation device 1 is provided with a gas feed unit 2 provided at the outside of a chamber 10, a plasma generation unit 3 installed inside the chamber 10, and a positive ion acceleration unit 4 constituted as part of the plasma generation unit 3.

The gas feed unit 2 is a portion for feeding a predetermined gas inside the chamber 10. Specifically, a bomb 21 containing H₂ (hydrogen gas) is connected to a flow control meter 22 through a valve 21a. The flow control meter 22 is connected through a valve 22a to a feed pipe 23. Further, a bomb 24 containing Ar (argon) gas is connected to a flow control meter 25 through a valve 24a. The flow control meter 25 is connected through a valve 25a to the feed pipe 23. The feed pipe 23 is connected to the chamber 10.

Due to this, by opening the valves 21a, 22a, 24a, and 25a and controlling the flow rates of gas from the bombs 21 and 24 by flow controls meters 22, 25, it is possible to feed the predetermined flow rates of H₂ gas and Ar gas to the chamber 10.

The plasma generation unit 3 is the portion which causes discharge of the H₂ gas and Ar gas fed by the gas feed unit 2 to the chamber 10 due to the high frequency electric field to generate plasma P.

Specifically, a flat plate anode electrode 30 is arranged at the top of the inside of the chamber 10 and is grounded at the outside of the chamber 10. On the other hand, a cathode electrode 31 of the same shape as the anode electrode 30 is arranged to face the anode electrode 30. The cathode electrode 31 is connected at the outside of the chamber 10 through a blocking capacitor 32 to a high frequency power source 33.

Due to this, the high frequency power source 33 is driven to form a high frequency electric field between the anode electrode 30 and the cathode electrode 31. If this is done, the electrons in the gas are accelerated by this electric field and strike the gas molecules. As a result, the gas present at the location between the anode electrode 30 and cathode electrode 31 (discharge location) discharges to generate the plasma P.

The positive ion acceleration unit 4 is a portion for making the cathode electrode 31 side a negative positive with respect to the anode electrode 30 and draws the H positive ions and Ar positive ions in the plasma P to the cathode electrode 31 side.

Specifically, the positive ion acceleration unit 4 is comprised of the cathode electrode 31 and the blocking capacitor 32. That is, electrons with several thousand times the mobility of the H positive ions and the Ar positive ions in the plasma accumulate in the blocking capacitor 32 in several cycles of the high frequency and give a negative potential to the cathode electrode 31. As a result, the negative potential cathode electrode 31 draws in the H positive ions and the Ar positive ions substantially uniformly filled in the plasma P. These positive ions strike the silicon wafer W.

Note that reference numeral 5 is a vacuum pump, while reference numeral 50 is a pressure sensor.

On the other hand, the heating device 6 is a device in the strain layer formation unit 1 for heating the silicon wafer W formed with the strain layer and is provided with a chamber 60, a wafer table 61 arranged in the chamber 60, and an infrared irradiation device 62.

The wafer table 61 is for carrying the silicon wafer W and has a large diameter hole 61a passing through it from the bottom to the top at its center portion.

The infrared irradiation device 62 is provided with a halogen heater 63 and a power source 64 for driving the halogen heater 63.

The halogen heater 63 is a known halogen heater and emits infrared rays as heat rays from a not shown lamp. This halogen heater 63 is arranged at the center of the bottom side of the large diameter hole 61a of the wafer table 61 in the state with the infrared ray irradiating side facing upward.

Due to this, when the power source 64 is used to drive the halogen heater 63, the infrared rays L are diffused and irradiated upward and the silicon wafer W carried on the wafer table 61 is heated from the lower side by the infrared rays L.

Next, an explanation will be given of the plasma gettering method executed using the plasma gettering system of this embodiment.

First, the gas feed step is executed.

That is, in FIG. 1, a silicon wafer W is inserted into a chamber 10 of the strain layer formation device 1 and is placed on the cathode electrode 31 in the state with the front surface Wa facing downward. That is, the back surface Wb of the silicon wafer W is made to face the anode electrode 30. In this state, the vacuum pump 5 is driven. When the pressure sensor 50 shows for example 0.02 Torr, the vacuum pump 5 is stopped and the inside of the chamber 10 is in a substantially vacuum state. Further, the valves 21a, 22a, 24a, and 25a of the plasma generation unit 3 are opened and the flow control meters 22, 25 are used to feed H₂ gas to the chamber 10 at a flow rate of for example 50 ml per minute and to feed Ar gas to the chamber 10 at a flow rate of for example 5 ml per minute and thereby fill the chamber 10 with a mixed gas of H₂ gas and Ar gas.

Next, the strain layer formation step is executed.

That is, in this state, the high frequency power source 33 is driven to output a high frequency at for example 2 kW and form an electric field of a frequency of 13.56 MHZ between the anode electrode 30 and the cathode electrode 31. The H positive ions and the Ar positive ions are filled substantially uniformly in the plasma P. In parallel with this, due to the function of the blocking capacitor 32, a negative potential of minus 800V is applied to the cathode electrode 31.

Due to this, the H positive ions and Ar positive ions present substantially uniformly in the plasma P are accelerated by the negative potential of the cathode electrode 31 to move toward the back surface Wb of the silicon wafer W and strike the back surface Wb.

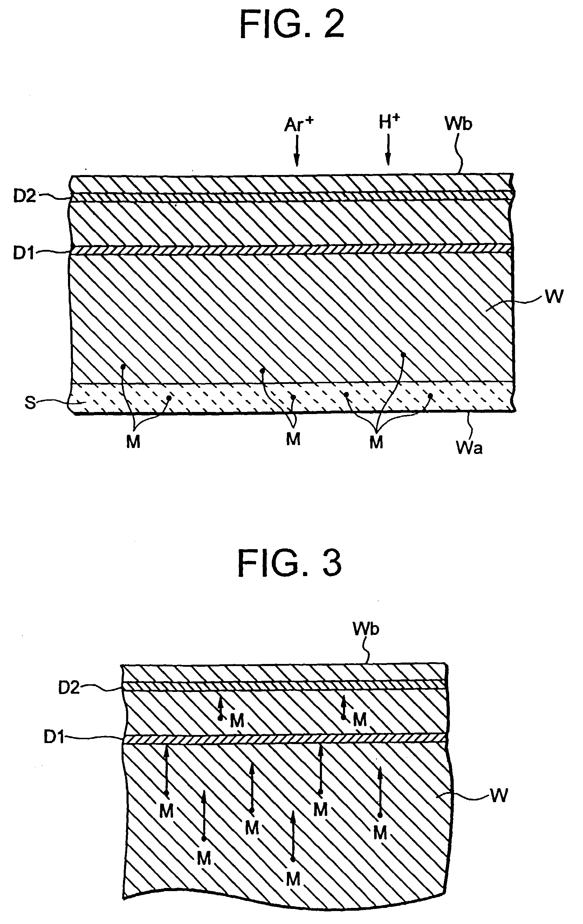

At this time, since the H positive ions are light and small in ion radius, as shown in FIG. 2, they penetrate the silicon wafer W deeply from the back surface Wb and give damage to the penetrated portion of the back surface Wb. On the other hand, since Ar positive ions are heavier and larger in ion radius than H positive ions, the distance of penetration from the back surface Wb is short. Therefore, a shallow portion of the silicon wafer W is damaged by the Ar positive ions.

If plasma is irradiated in this way for about 10 minutes, as shown in FIG. 2, the H positive ions form a strain layer D1 at a depth of approximately 400_{Å} from the back surface Wb and the Ar positive ions form a strain layer D2 at a shallow portion near the back surface Wb.

Finally, the silicon wafer W formed with the strain layers D1 and D2 is taken out from the chamber 10 and conveyed to the heating device 6 for the heating step.

That is, the silicon wafer W formed with the strain layers D1 and D2 is placed on the wafer table 61 with the front surface Wa facing downward as shown in FIG. 1. Suitably thereafter, the power source 64 is used to drive the halogen heater 63 and irradiate infrared rays L on the downward facing front surface Wa, whereby the silicon wafer W is heated from the front surface Wa side.

When the silicon wafer W is heated, as shown in FIG. 2, the heavy metal impurities M present in the electrically active region S of the surface Wa and nearby that region diffuse.

If this is done, as shown in FIG. 3, the heavy metal impurities M move to the back surface Wb side and are captured by the strain layer D1. The heavy metal impurities M escaping capture by the strain layer D1 are captured by the strain layer D2 near the back surface Wb. As a result, the heavy metal impurities M which were present in the electrically active region S and its vicinity are substantially completely captured by the strain layers D1 and D2.

In this way, according to the plasma gettering method of this embodiment, the H positive ions and Ar positive ions caused by the plasma discharge form the strain layers D1 and D2 and therefore there is none of the environmental pollution which had been a problem in the sand blasting method. Further, since the H positive ions and the Ar positive ions are irradiated over the entire surface of the back surface Wb of the silicon wafer W, it is possible to form uniform strain layers D1 and D2 regardless of the diameter of the silicon wafer W. Further, by just irradiating H positive ions and Ar positive ions, it is possible to form strain layers D1, D2 in the silicon wafer W, so the strain formation process is simple. Further, since the majority of the heavy metal impurities M are captured by the strain layer D1 and the heavy metal impurities M escaping capture are reliably captured by the strain layer D2, substantially complete gettering of the heavy metal impurities M becomes possible.

### (Second Embodiment)

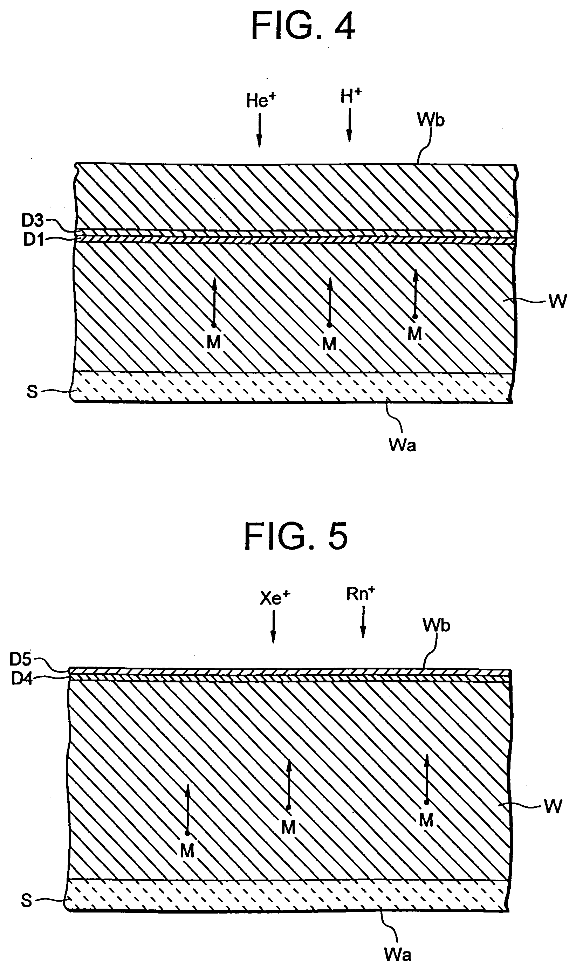

FIG. 4 is a schematic cross-sectional view of a plasma gettering method according to a second embodiment of the present invention.

The plasma gettering method of this embodiment differs from the first embodiment in the point that the H positive ions and He positive ions obtained by plasma discharge of H gas and He gas are irradiated on the back surface Wb of the silicon wafer W.

By irradiating the both light and small ion radius H positive ions and He positive ions, as shown in FIG. 4, it is considered that the strain layer D1 formed from the H positive ions and the strain layer D3 formed from the He positive ions are formed in proximity with each other.

Therefore, the heat diffused heavy metal impurities M are captured by the two layers of the strain layers D1, D3, but since the strain layers D1, D3 are formed deep in the silicon wafer W, that is, positions close to the electrically active region S, the time for capturing the heavy metal impurities M becomes shorter.

Therefore, it becomes possible to shorten the time for the gettering and improve the efficiency of the gettering work.

The rest of the configuration and the mode of operation and advantageous effects are similar to those of the first embodiment explained above, so explanations thereof will be omitted.

### (Third Embodiment)

FIG. 5 is a schematic cross-sectional view of a plasma gettering method according to a third embodiment of the present invention.

The plasma gettering method of this embodiment differs from the first and second embodiments in the point that use is made of a heavy inert gas other than He gas.

For example, Xe (xenon) gas or Rn (radon) gas is made to discharge to generate a plasma and irradiate formed Xe positive ions or Rn positive ions on the back surface Wb of the silicon wafer W.

If this is done, since Xe positive ions or Rn positive ions are large in weight and ion radius, the silicon wafer W receives a large shock by the collision of the ions. Therefore, the strain layer D4 resulting from the Xe positive ions or strain layer D5 resulting from the Rn positive ions are formed in a short time at a shallow portion near the front surface Wb.

According to the plasma gettering method of this embodiment in this way, positive ions of a heavy and large ion radius inert gas are irradiated on the silicon wafer W, so it is possible to form strain layers in a short time and possible to quickly perform the strain layer formation step.

The rest of the configuration and the mode of operation and advantageous effects are similar to those of the first and second embodiments explained above, so explanations thereof will be omitted.

Note that the present invention is not limited to the above embodiments. Various modifications and changes may be made within the scope of the gist of the invention.

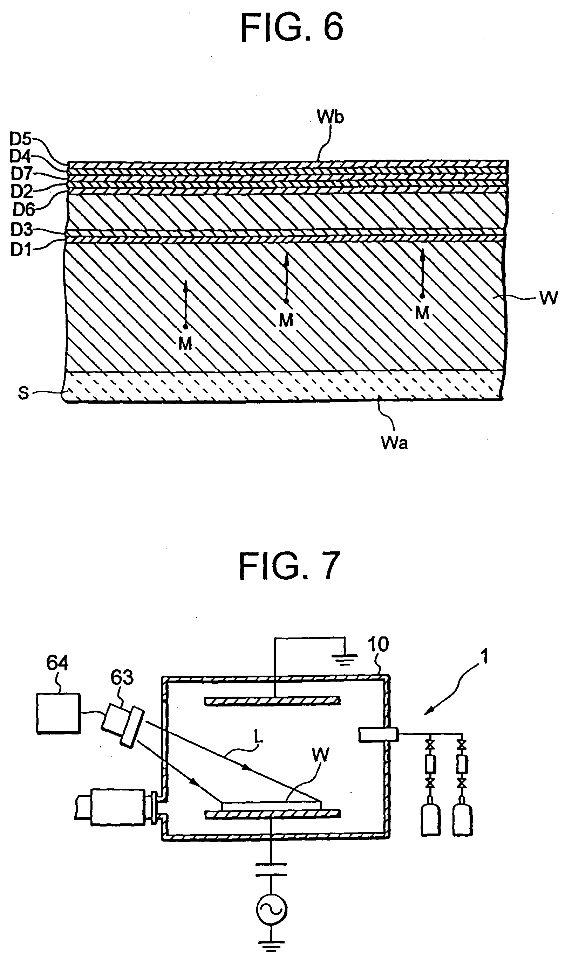

If H positive ions and positive ions of an inert gas are accelerated by the same voltage and made to strike the silicon wafer W, due to the difference in weights and radii of the ions, theoretically, as shown in FIG. 6, strain layers D1, D3 resulting from the H positive ions and He positive ions are formed deep in the silicon wafer W and a strain layer D6 of Ne positive ions, a strain layer D2 of Ar positive ions, a strain layer D7 of Kr positive ions, a strain layer D4 of Xe positive ions, and a strain layer D5 of Rn positive ions are formed stacked on each other at the shallow part of the silicon wafer W.

Therefore, in the above embodiments, the H positive ions and Ar positive ions form the strain layers D1 and D2, the H positive ions and He positive ions form the strain layers D1 and D3, and the Xe positive ions and Rn positive ions form the strain layers D4 and D5, but the invention is not limited to these. By using the desired type of positive ions among H positive ions and positive ions of inert gases to irradiate the silicon wafer W, it is possible to form a desired number of strain layers at desired locations of the silicon wafer W.

Further, by controlling the negative voltage of the cathode electrode 31 accelerating the positive ions, it is possible to adjust the depth of the strain layers formed by the positive ions.

Further, in the above embodiments, as the heating device, use was made of a heating device 6 separate from the strain layer formation device, but as shown in FIG. 7, it is possible to arrange the halogen heater 63 and power source 64 at the outside of the strain layer formation device 1 and combine the strain layer formation device 1 and heater device. Due to this, by irradiating infrared rays L on the silicon wafer W from the halogen heater 63 after the strain layer formation step in the chamber 10, it is possible to heat the silicon wafer W.

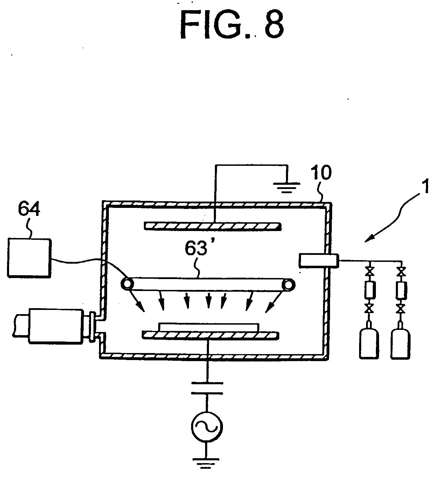

Further, it is also possible to combine the heater device with the strain layer formation device 1 and, as shown in FIG. 8, arrange a ring-shaped halogen heater 63' to surround the discharge location in the chamber 10.

As explained above in detail, according to the aspects of the invention, positive ions are irradiated on the back surface of the wafer to form a strain layer, so there is no need for washing as in the sand blasting method and no problem of environment pollution. Further, since much smaller positive ions are irradiated over the entire back surface of the wafer compared with silica particles etc., it is possible to form a strain layer uniformly over the entire surface of the wafer regardless of the diameter of the wafer.

Further, since there is no need to form a polysilicon film such as with the PBS method, there is no need to adjust the initial oxygen concentration of the wafer considering the precipitation of oxygen. Further, there is no need for means or control of phosphorus diffusion as in the phosphorus diffusion method. Therefore, it is possible to simplify the process by that amount.

Further, according to the aspect of the invention, since light and small ion radius hydrogen positive ions or helium positive ions are irradiated on the wafer, it is possible to form extremely fine strain layers deep in the wafer. That is, by adjusting the size of the negative potential, it is possible to form a strain layer at a desired position of the wafer.

Further, according to the aspect of the invention, by irradiating positive ions of a heavy and large ion radius inert gas on the wafer to give a large shock and form a strain layer, it is possible to form a strain layer in a short time.

## Claims

1. A plasma gettering process comprising:
a gas feed step for feeding a predetermined gas to a discharge location;
a strain layer forming step for discharging the gas supplied to the discharge location to generate plasma, making the side of the wafer arranged with its back surface facing the discharge location a negative potential with respect to a plasma potential, irradiating positive ions in the plasma on the entire back surface of the wafer, and thereby forming a strain layer in the wafer; and
a heat treatment step for heating the wafer formed with the strain layer in said strain layer formation step to a predetermined temperature to cause the impurities in the wafer to be captured in the strain layer.

2. A plasma gettering method as set forth in claim 1, wherein at least one of hydrogen gas and helium gas is supplied to the discharge location in said gas feed step.

3. A plasma gettering method as set forth in claim 1, wherein at least one type of inert gas among inert gases other than helium gas is supplied to the discharge location in said gas feed step.

4. A plasma gettering method as set forth in claim 2, wherein at least one type of inert gas among inert gases other than helium gas is added to at least one of hydrogen gas and helium gas and supplied to the discharge location in said gas feed step.

5. A plasma gettering system comprising:
a strain layer forming device having a gas feed unit for feeding a predetermined gas to a discharge location, a plasma generating unit for discharging the gas supplied from the gas feed unit to the discharge location to generate plasma, and a positive ion acceleration unit for making the side of the wafer arranged with its back surface facing the discharge location a negative potential and irradiating positive ions in the plasma on the entire back surface of the wafer; and
a heating device for heating the wafer formed with the strain layer in said strain layer forming device to a predetermined temperature.
